# FASCICULE DE BREVET EUROPEEN

(11) **EP 3 721 482 B1**
(45) Date de publication et mention de la délivrance du brevet: **03.08.2022**
(21) Numéro de dépôt: 18807667.3
(22) Date de dépôt: 30.11.2018
(51) Int. Cl.: H01L 31/054, H01L 31/048, H01L 31/18

(54) **FABRICATION D'UN SOUS-MODULE A CONCENTRATION UTILISANT LES PROCEDES D'ASSEMBLAGE DU PHOTOVOLTAÏQUE**
HERSTELLUNG EINES KONZENTRATIONSSUBMODULS UNTER VERWENDUNG VON VERFAHREN ZUR FOTOVOLTAISCHEN ANORDNUNG
PRODUCTION OF A CONCENTRATING SUB-MODULE USING PHOTOVOLTAIC ASSEMBLY METHODS

(30) Priorité: 07.12.2017 FR 1761774
(43) Date de publication de la demande: 14.10.2020
(73) Titulaire: Commissariat à l'Energie Atomique et aux Energies Alternatives, 75015 Paris (FR)
(72) Inventeur: ROUJOL, Yannick, 38890 Saint-Chef (FR); BARBOT, Anthony, 73000 Chambery (FR); BAUDRIT, Mathieu, 73000 Chambery (FR); SERAINE, Caroline, 73800 Sainte-Helene-Du-Lac (FR); WEICK, Clément, 38000 Grenoble (FR)
(74) Mandataire: Marks & Clerk France
(86) Numéro de dépôt international: PCT/EP2018/083183
(87) Numéro de publication internationale: WO 2019/110448

(56) Documents cités:
- EP-A2- 1 715 260
- EP-B1- 1 715 260
- WO-A1-2009/002350
- WO-A2-2010/017422
- US-A1- 2013 081 668

## Description

L'invention concerne la fabrication d'éléments pour modules photovoltaïques à concentration, et plus particulièrement pour les modules photovoltaïques à concentration basés sur des concentrateurs paraboliques linéaires réfléchissants (ou miroirs). Ces éléments sont appelés sous-modules photovoltaïques à concentration.

Ces sous-modules comprennent chacun un dispositif optique de concentration de la lumière (souvent appelé miroir ou concentrateur) et des cellules photovoltaïques formant un récepteur photovoltaïque et disposées en face arrière du miroir ou concentrateur, à l'opposé de la face réfléchissante.

Lorsqu'ils sont mis en œuvre, ils permettent de former un module photovoltaïque à concentration, le concentrateur d'un sous-module présentant une ligne focale située au dos du concentrateur d'un sous-module voisin. Le récepteur photovoltaïque du sous-module voisin est situé au niveau de cette ligne focale. Ainsi, chaque miroir joue, en plus de son rôle de concentrateur, le rôle de support pour un récepteur photovoltaïque. Le module photovoltaïque à concentration consiste donc en un assemblage de plusieurs éléments généralement identiques, appelés sous-modules.

Le concentrateur ou miroir de ces sous-modules à concentration solaire possède une surface réfléchissante composée d'un miroir et une face arrière sur laquelle une ou un ensemble de cellules photovoltaïques est fixé (voir les documents US 1993/5180441, US 2013/081668 A1 et WO 2010/017422 A2). La forme parabolique du module permet de concentrer les rayons lumineux. La lumière arrivant sur un premier sous-module est réfléchie par la surface réfléchissante, de manière à concentrer la lumière sur la cellule photovoltaïque d'un second sous-module situé à proximité du premier module.

La surface réfléchissante peut être composée d'une couche d'un métal fortement réfléchissant recouverte d'un film protecteur, ou composée d'une couche métallique collée à un substrat comprenant des matériaux composites organiques (voir le document US 1994 / 5344496). Un maillage d'un matériau à forte conductivité thermique peut également être ajouté à l'arrière de la surface réfléchissante pour améliorer la dissipation de chaleur du sous-module. La fabrication de ces sous-modules est assez complexe, car elle nécessite de nombreuses étapes, comme la formation et le polissage de la surface réfléchissante, ou le traitement de cette surface. Il faut aussi prévoir une étape de collage des cellules photovoltaïques sur le miroir.

Il est également possible de réaliser un sous-module photovoltaïque, de forme parabolique, à concentration (voir le document US 2007 / 0256726), dans lequel la concentration de la lumière n'est pas faite sur le point focal d'un miroir, mais sur le point focal d'un élément solide complexe composé de plusieurs miroirs. Dans ce document, les cellules photovoltaïques sont placées sur la face avant du concentrateur. Afin d'éviter la formation de bulles d'air entre les différents composants du sous-module, plusieurs laminations sous vide sont réalisées pour intégrer l'optique, les cellules photovoltaïques et le câblage. La lamination sous vide permet ainsi d'assurer une meilleure adhésion de l'optique, des cellules ou du câblage sur leur support respectif en utilisant pas ou peu de colle. Comme ces différentes laminations forment une structure composite planaire, il y a une autre étape de fabrication, durant laquelle des miroirs sont fixés à des surfaces convexes ou concaves pour donner la forme parabolique servant à concentrer la lumière sur le point focal de l'élément solide optique.

Le document US 2004 / 0118395 présente un concentrateur solaire parabolique comprenant une structure en nid d'abeilles entourée de deux peaux. Cette structure en nid d'abeilles permet d'avoir un concentrateur léger, capable de supporter des miroirs fins ou une surface réfléchissante fine tout en ayant une bonne tenue mécanique. Néanmoins, cet élément ne comporte aucune cellule photovoltaïque, car il est destiné au chauffage d'un fluide. De plus, il est fabriqué en plusieurs étapes, notamment la déformation à froid de la surface réfléchissante, la fixation des miroirs avec une colle sur l'une des peaux, et le traitement de surface des peaux et des miroirs.

L'invention vise à remédier aux inconvénients précités de l'art antérieur, plus particulièrement elle vise à proposer un procédé de fabrication, ne comportant qu'une seule étape, d'un sous-module photovoltaïque à concentration.

Un objet de l'invention est donc un procédé de fabrication d'un sous-module solaire photovoltaïque à concentration, muni d'une face réfléchissante ayant une forme géométrique prédéfinie concave, caractérisé en ce que le procédé comprend la lamination, en une seule étape, d'un ensemble multi-couches comprenant successivement un élément structurel muni d'une première face réfléchissante et d'une seconde face, opposée à la première, un récepteur photovoltaïque, placé sur la seconde face de l'élément structurel, une couche en matériau d'encapsulation transparent, recouvrant le récepteur photovoltaïque, et une couche de protection transparente recouvrant l'encapsulant transparent, la couche de protection transparente et la couche en matériau d'encapsulation recouvrant au moins toute la surface du récepteur photovoltaïque, et caractérisé en ce que pendant la lamination, la face réfléchissante de l'élément structurel est mise en forme par mise en contact avec une surface convexe d'une contre-forme, pour obtenir la face réfléchissante de forme géométrique prédéfinie concave.

Selon des modes de réalisation particuliers de l'invention :
- La forme géométrique prédéfinie concave de ladite face réfléchissante peut être parabolique ;
- La lamination peut être une lamination à chaud sous-vide, dont la température est, de préférence, comprise entre 120 °C et 170 °C ;
- Le matériau d'encapsulation peut être en EVA, polyoléfine, silicone, polyuréthane thermoplastique, polyvinyl butyral, polyoléfine fonctionnelle ou en ionomère ;
- La couche de protection transparente peut être en ECTFE, FEP, PMMA, PC, ETFE, PVDF, PET, en verre ou en CPI ;
- Le récepteur photovoltaïque peut être un ensemble de cellules photovoltaïques, interconnectées par des fils sur un récepteur de type PCB-SMI, ou un ensemble de cellules photovoltaïques interconnectées par rubans, les cellules photovoltaïques étant des cellules en silicium ou des cellules multi-jonctions ;
- L'élément structurel peut être formé d'une âme entourée de deux peaux, l'une des deux peaux étant recouverte d'un film réfléchissant formant la première face réfléchissante du sous-module, et dans ce cas, les peaux pouventt être en matériau préimprégné polymère / fibre, le polymère étant choisi parmi le polyester, l'époxy, ou l'acrylique et la fibre étant choisie parmi le verre, le carbone, ou l'aramide, et l'âme peut être une structure en nid d'abeilles, avantageusement en aluminium, en aramide de type Nomex, en polypropylène, ou en polycarbonate, ou l'âme peut être une mousse, avantageusement en PET, PU, PVC, PEI ou PMI ;
- Le film réfléchissant peut être un film en matériau polymère contenant un dépôt d'argent ou d'aluminium ; et
- L'élément structurel peut comprendre un miroir en aluminium.

Un autre exemple ne faisant pas partie de l'invention est sous-module solaire photovoltaïque à concentration muni d'une face réfléchissante ayant une forme géométrique prédéfinie concave, comprenant un élément structurel muni d'une première face réfléchissante et d'une seconde face, opposée à la première face, l'élément structurel comprenant une âme entourée de deux peaux, l'une des deux peaux étant directement en contact avec une couche réfléchissante formant la première face réfléchissante de l'élément structurel et la face réfléchissante du sous-module, la deuxième peau formant la deuxième face de l'élément structurel, un récepteur photovoltaïque, placé directement en contact avec la seconde face de l'élément structurel, une couche en matériau d'encapsulation transparent, recouvrant le récepteur photovoltaïque, et une couche de protection transparente, formant une deuxième face du sous-module opposée à la face réfléchissante, recouvrant la couche en matériau d'encapsulation transparent.

Un autre exemple ne faisant pas partie de l'invention est un sous-module photovoltaïque à concentration muni d'une face réfléchissante ayant une forme géométrique prédéfinie concave, comprenant un élément structurel muni d'une première face réfléchissante et d'une seconde face, opposée à la première face, l'élément structurel comprenant un miroir en aluminium formant la première face réfléchissante de l'élément structurel et la face réfléchissante du sous-module, un récepteur photovoltaïque, placé directement en contact avec la seconde surface de l'élément structurel, une couche en matériau d'encapsulation transparent, recouvrant le récepteur photovoltaïque, et une couche de protection transparente, formant une deuxième face du sous-module opposée à la face réfléchissante, recouvrant la couche en matériau d'encapsulation transparent.

D'autres caractéristiques, détails et avantages de l'invention ressortiront à la lecture de la description faite en référence aux figures annexées données à titre d'exemple et qui représentent, respectivement :
- La figure la, une coupe d'un module composé de deux sous-modules illustrant le fonctionnement d'un module photovoltaïque à concentration ;
- La figure 1b, les dimensions caractéristiques d'un module photovoltaïque à concentration ; et
- La figure 2, une illustration d'un procédé de fabrication d'un sous-module photovoltaïque à concentration selon des modes de réalisation de l'invention.

La lamination est une étape de mise sous pression à chaud pour coller et presser deux ou plusieurs couches de matière. La pression et la température de cette étape sont dépendantes des matériaux employés. La lamination permet ici la mise en forme du concentrateur par application sur une contre-forme.

Les éléments présentés dans les figures ne sont pas à l'échelle, les proportions ne sont donc pas représentatives de la réalité.

La figure la présente une coupe de deux sous-modules photovoltaïques à concentration illustrant le fonctionnement d'un module photovoltaïque à concentration. Seuls deux sous-modules M1 et M2 sont présentés, mais le fonctionnement décrit ci-dessous peut s'appliquer à une multitude de sous-modules. Des rayons lumineux RL arrivent sur une première face FR réfléchissante d'un premier sous-module M1. La face FR réfléchissante est habituellement constituée d'un miroir cylindrique parabolique. La forme parabolique du miroir du sous-module M1 permet de faire converger les rayons lumineux RL vers le foyer du miroir dont la position est précisément calculée afin d'y placer un récepteur photovoltaïque R. Cette position correspond également à un point sur une deuxième face FA d'un second sous-module M2. Les miroirs paraboliques ont des fonctions thermique, structurelle et optique. En effet, en plus de concentrer la lumière en un point, ils permettent de dissiper la chaleur avec une température maximale Tₘₐₓ au niveau du récepteur R et une température minimale Tₘᵢₙ sur la partie inférieure du sous-module, le récepteur R étant positionné sur la partie supérieure. La dissipation de chaleur est représentée par les flèches sur la figure, et la flèche reliant Tₘₐₓ à Tₘᵢₙ représente le gradient de température le long du sous-module (US 1993 / 5180441). Pour pouvoir réaliser un système à plusieurs sous-modules, la deuxième face FA du sous-module M1 peut également porter un récepteur photovoltaïque et la face FR du sous-module M2 peut être réfléchissante.

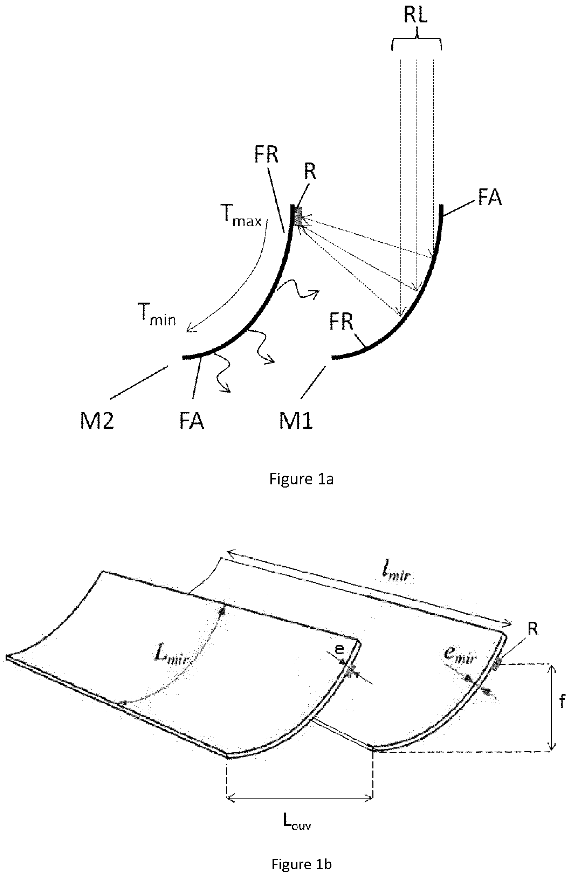

La figure 1b présente les dimensions caractéristiques d'un module photovoltaïque à concentration. La forme donnée aux sous-modules est une portion de parabole de distance focale f. La largeur développée de cette portion de parabole est donnée par Lₘᵢᵣ. La distance entre deux sous-modules est donnée par Lₒᵤᵥ. La longueur des sous-modules est donnée par Iₘᵢᵣ, l'épaisseur du concentrateur par eₘᵢᵣ et celle des sous-modules par e.

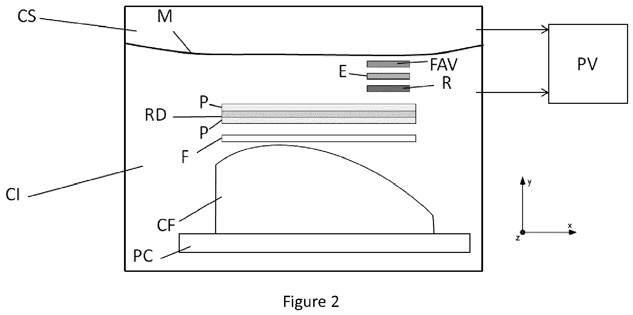

La figure 2 présente une illustration d'un procédé de fabrication d'un sous-module photovoltaïque à concentration selon un mode de réalisation de l'invention. Une couche transparente FAV, recouvrant un encapsulant transparent E, lui-même recouvrant un récepteur photovoltaïque R, et un élément structurel sont placés sur une contre-forme CF dans la chambre inférieure CI d'un laminateur, et plus particulièrement d'un laminateur tel que ceux utilisés dans le domaine de fabrication des modules photovoltaïques classiques plans.

L'élément structurel a une face réfléchissante et il comprend en particulier une âme RD, également appelée matériau de renfort, entourée de deux peaux P, dont l'une est recouverte d'un film réfléchissant F.

La couche transparente FAV et l'encapsulant E recouvrent au moins toute la surface du récepteur R, le récepteur R étant placé entre l'élément structurel et l'encapsulant E.

L'élément structurel et le film réfléchissant R ont la même surface que le sous-module désiré.

Les chambres inférieure CI et supérieure CS du laminateur sont mises sous vide grâce à une pompe à vide PV.

L'ensemble couche transparente FAV, encapsulant transparent E, récepteur photovoltaïque R, peaux P, âme RD et film réfléchissant F, noté (FAV, E, R, P, RD, P, F), est plan et subit une lamination à chaud, de préférence sous vide, avec une mise en forme à l'aide de la contre-forme CF.

La contre-forme CF permet de définir la forme parabolique concave de la face réfléchissante du sous-module lors de l'étape de lamination. Elle présente donc une surface destinée à être en contact direct avec la face réfléchissante de l'élément structurel lors de l'étape de lamination. Cette surface a une géométrie pré-définie correspondant à la forme que l'on souhaite obtenir pour la face réfléchissante de l'élément structurel. La contre-forme CF peut être en matériau métallique ou composite, et est recouverte d'une couche anti-adhésive (en Teflon, par exemple). Le matériau de la contre-forme CF est choisi de manière à être un conducteur thermique et à présenter une bonne tenue mécanique à la température de lamination.

Les conditions de température, pression et de durée de cette étape de lamination sont adaptées par l'homme du métier en fonction des matériaux à laminer. A titre d'exemple, l'étape de lamination peut au moins durer 15 minutes, la température de la lamination est avantageusement comprise entre 120 °C et 170 °C et la pression de lamination peut être d'environ 1000 mbar (10⁵ Pa).

L'épaisseur de l'ensemble est de préférence inférieure à 10 mm afin de maintenir et d'assurer une forme parabolique optimale à l'ensemble. L'épaisseur peut également être limitée par la hauteur utile du laminateur et de la contre-forme CF. Durant la lamination, la contre-forme CF et l'ensemble (FAV, E, R, P, RD, P, F) reposent par exemple sur une plaque chauffante PC et une charge verticale homogène est appliquée progressivement sur le dessus grâce à la membrane M, épousant parfaitement les formes. Durant la lamination, il est nécessaire de réticuler suffisamment l'encapsulant E et de cuire correctement les différents éléments composant le module qui sont situés à des distances plus ou moins proches du plateau chauffant PC. Pour cela, le programme de lamination à chaud est optimisé en température, pression, et durée selon les matériaux utilisés.

Selon un mode de réalisation de l'invention, les peaux P sont en matériau préimprégné polymère / fibre, qui permet d'obtenir l'adhésion du film réfléchissant F avec l'âme RD. Le préimprégné a une épaisseur inférieure à 200 µm et le pourcentage de résine est compris entre 40 et 55 %. Le polymère est choisi parmi du polyester, de l'époxy ou de l'acrylique, tandis que la fibre est choisie parmi du verre, du carbone, ou de l'aramide.

Selon un autre mode de réalisation de l'invention, l'âme RD est une structure en nid d'abeilles en aramide de type Nomex, en polypropylène, en polycarbonate ou en aluminium.

Selon un autre mode de réalisation de l'invention, l'âme RD est une mousse en PET (polytéréphtalate d'éthylène), PU (polyuréthane), PVC (polychlorure de vinyle), PEI (polyéthérimide) ou en PMI (polyméthyneimine).

Selon un autre mode de réalisation de l'invention, l'encapsulant transparent E a une épaisseur inférieure à 500 µm et est en élastomère réticulé, tel que l'EVA (éthylvinylacétate), ou en élastomère thermoplastique ou en copolymère thermoplastique réticulé ioniquement (IONOMER). Dans le cas d'un élastomère thermoplastique, l'encapsulant E est plus particulièrement en polyoléfine, en silicone, en PU thermoplastique, en polyvinyl butyral ou en polyoléfine fonctionnelle.

Selon un autre mode de réalisation de l'invention, la couche transparente FAV a une épaisseur inférieure à 200 µm et est en ECTFE (ou HALAR, copolymère d'éthylène de chlorotrifluoroéthylène), FEP (fluoroéthylène propylène), PMMA (polyméthcrylate de méthyle), PC (polycarbonate), ETFE (éthylène tétrafluoroéthylène), PVDF (fluorure de polyvinylidène), PET, verre mince ou en CPI (polyimide transparent).

Selon un autre mode de réalisation de l'invention, le film réfléchissant F est un film polymère avec un dépôt d'aluminium ou avec un dépôt d'argent. L'idéal est que le film réfléchissant F soit suffisamment épais pour que l'éventuelle âme RD en nid d'abeilles ne soit pas visible sur la surface réfléchissante du module, afin de ne pas perturber la concentration la lumière, tout en gardant un poids total du sous-module faible. Avantageusement le film a une épaisseur comprise entre 200 et 250 µm.

Le choix des matériaux constituant l'ensemble (FAV, E, R, P, RD, P et F) dépend du poids du sous-module visé, du respect de la forme parabolique assurant une bonne concentration et des conditions d'environnement du module (terrestre, stratosphérique ou spatial). Ainsi, en utilisant un préimprégné carbone / epoxy, de grammage compris entre 80 g/m² et 300 g/m², associé à un nid d'abeilles en aluminium d'une épaisseur de 3 mm, on peut réaliser un sous-module rigide et d'un poids faible, bien inférieur à celui d'un module classique (différence de 30 %).

Selon un autre mode de réalisation de l'invention, le récepteur photovoltaïque R est composé de cellules photovoltaïques interconnectées par des fils (wire-bonding) et montées sur un récepteur de type SMI-PCB (Insulated Metal Substrate - Printed Circuit Board ou circuit imprimé sur un substrat métallique isolé) par brasage ou collage en utilisant, par exemple, une colle d'argent conductrice. Les cellules peuvent également être interconnectées entre elles par rubans ce qui permet de ne pas utiliser de récepteur SMI-PCB. Les cellules peuvent être des cellules en silicium ou des cellules multi-jonctions en matériaux semi-conducteurs de type III-V ou de type II-VI ou en matériau ayant une structure perovskite sur silicium. Les cellules peuvent également être collées entre elles par brasage ou par collage, en utilisant par exemple une colle d'argent conductrice.

Un exemple de mise en œuvre de l'invention est le suivant :
- La couche transparente FAV est en HALAR (ECTFE) ou en FEP avec une épaisseur de 25 µm et un grammage de 54 g/m² ;
- L'encapsulant transparent E est en ionomère avec une épaisseur de 50 µm et un grammage de 45 g/m² ;
- Le récepteur photovoltaïque R est constitué de cellules solaires triple-jonction de largeur 10 mm et de longueur 10 mm et d'un récepteur PCB-SMI d'épaisseur 75 µm ;
- L'âme RD est une âme en nid d'abeilles en aluminium d'épaisseur 3 mm et de grammage 78 g/m² entourée de deux peaux P en préimprégné carbone / epoxy de grammage 110 g/m² ;
- Le film réfléchissant F est constitué d'un film réfléchissant en PET, d'un dépôt aluminisé et d'un vernis de protection, le film F ayant une épaisseur de 71 µm et un grammage de 105 g/m².

L'ensemble est déposé sur une contre-forme CF en aluminium, ayant une forme parabolique de hauteur 28 mm, dans la chambre inférieure CI d'un laminateur, de hauteur utile 35 mm. La température de la plaque chauffante est de 150 °C. La chambre inférieure CI est dégazée pendant 300 s : les chambres inférieure CI et supérieure CS sont mises sous vide grâce à la pompe à vide PV. Puis durant une seconde phase de 600 s, une charge verticale homogène (à l'aide de la membrane M) est appliquée progressivement sur le dessus de la contre-forme CF, posée sur la plaque chauffante PC, à une vitesse de 1400 mbar/min jusqu'à un palier de 1000 mbar.

Les sous-modules ont une largeur développée Lₘᵢᵣ de 180 mm, une longueur Iₘᵢᵣ de 1 m et une largeur de cellules de 10 mm. Leur distance focale f est de 75 mm et la distance entre deux sous-modules est de Lₒᵤᵥ = 150 mm.

Selon un autre objet de l'invention, l'élément structurel comprend un miroir en aluminium ayant une épaisseur inférieure à 0,5 mm. L'ensemble couche transparente FAV, encapsulant E, récepteur photovoltaïque R et miroir en aluminium subit une lamination en une seule étape sur une contre-forme CF de la même manière que précédemment. Dans ce cas, le poids total du sous-module est légèrement supérieur (30 %). Sa tenue mécanique est plus faible et il nécessitera donc des supports complémentaires : trois supports sont en effet nécessaires pour un sous-module de longueur 1 m alors que deux supports sont nécessaires pour un sous-module de même dimension en matériau composite. Cependant, sa durée de vie est supérieure, car sa partie réfléchissante se dégrade moins contrairement aux couches organiques.

## Revendications

1. Procédé de fabrication d'un sous-module solaire photovoltaïque à concentration, muni d'une face réfléchissante ayant une forme géométrique prédéfinie concave, **caractérisé en ce que** qu'il comprend la lamination, en une seule étape, d'un ensemble multi-couches comprenant successivement :
- Un élément structurel (P, RD, F) muni d'une première face réfléchissante (F) et d'une seconde face, opposée à la première ;
- Un récepteur photovoltaïque (R), placé sur la seconde face de l'élément structurel ;
- Une couche en matériau d'encapsulation transparent (E), recouvrant le récepteur photovoltaïque ; et
- Une couche de protection transparente (FAV) recouvrant la couche en matériau d"encapsulation transparent; la couche de protection transparente et la couche en matériau d'encapsulation recouvrant au moins toute la surface du récepteur photovoltaïque ;
et **en ce que**, pendant la lamination, la face réfléchissante de l'élément structurel est mise en forme par mise en contact avec une surface convexe d'une contre-forme (CF), pour obtenir la face réfléchissante de forme géométrique prédéfinie concave.

2. Procédé de fabrication d'un sous-module solaire photovoltaïque à concentration selon la revendication précédente dans lequel la forme géométrique prédéfinie concave de ladite face réfléchissante est parabolique.

3. Procédé de fabrication d'un sous-module solaire photovoltaïque à concentration selon l'une des revendications précédentes, dans lequel ladite lamination est une lamination à chaud sous-vide, dont la température est, de préférence, comprise entre 120 °C et 170 °C.

4. Procédé de fabrication d'un sous-module solaire photovoltaïque à concentration selon l'une des revendications précédentes, dans lequel le matériau d'encapsulation est en EVA, polyoléfine, silicone, polyuréthane thermoplastique, polyvinyl butyral, polyoléfine fonctionnelle ou en ionomère.

5. Procédé de fabrication d'un sous-module solaire photovoltaïque à concentration selon l'une des revendications précédentes, dans lequel ladite couche de protection transparente est en ECTFE, FEP, PMMA, PC, ETFE, PVDF, PET, en verre ou en CPI.

6. Procédé de fabrication d'un sous-module solaire photovoltaïque à concentration selon l'une des revendications précédentes, dans lequel ledit récepteur photovoltaïque est un ensemble de cellules photovoltaïques, interconnectées par des fils sur un récepteur de type PCB-SMI.

7. Procédé de fabrication d'un sous-module solaire photovoltaïque à concentration selon l'une des revendications 1 à 5, dans lequel ledit récepteur photovoltaïque est un ensemble de cellules photovoltaïques interconnectées par rubans.

8. Procédé de fabrication d'un sous-module solaire photovoltaïque à concentration selon l'une des revendications 1 à 7, dans lequel lesdites cellules photovoltaïques sont des cellules en silicium.

9. Procédé de fabrication d'un sous-module solaire photovoltaïque à concentration selon l'une des revendications 1 à 7, dans lequel lesdites cellules photovoltaïques sont des cellules multi-jonctions.

10. Procédé de fabrication d'un sous-module solaire photovoltaïque à concentration selon l'une des revendications précédentes, dans lequel ledit élément structurel est formé d'une âme entourée de deux peaux, l'une des deux peaux étant recouverte d'un film réfléchissant formant la première face réfléchissante du sous-module.

11. Procédé de fabrication d'un sous-module solaire photovoltaïque à concentration selon la revendication 10, dans lequel lesdites peaux sont en matériau préimprégné polymère / fibre, le polymère étant choisi parmi le polyester, l'époxy, ou l'acrylique et la fibre étant choisie parmi le verre, le carbone, ou l'aramide.

12. Procédé de fabrication d'un sous-module solaire photovoltaïque à concentration selon l'une des revendications 10 et 11, dans lequel l'âme est une structure en nid d'abeilles, avantageusement en aluminium, en aramide de type Nomex, en polypropylène, ou en polycarbonate.

13. Procédé de fabrication d'un sous-module solaire photovoltaïque à concentration selon l'une des revendications 10 et 11, dans lequel l'âme est une mousse, avantageusement en PET, PU, PVC, PEI ou PMI.

14. Procédé de fabrication d'un sous-module solaire photovoltaïque à concentration selon l'une des revendications 10 à 13, dans lequel ledit film réfléchissant est un film en matériau polymère contenant un dépôt d'argent ou d'aluminium.

15. Procédé de fabrication d'un sous-module solaire photovoltaïque à concentration selon l'une des revendications 1 à 9, dans lequel ledit élément structurel comprend un miroir en aluminium.

## Patentansprüche

1. Verfahren zum Herstellen eines solaren photovoltaischen Konzentrationssubmoduls, das mit einer reflektierenden Fläche mit einer vordefinierten konkaven geometrischen Form versehen ist, **dadurch gekennzeichnet, dass** es die Laminierung, in einem einzigen Schritt, einer mehrschichtigen Baugruppe umfasst, die nacheinander Folgendes umfasst:
- ein Strukturelement (P, RD, F), das mit einer ersten reflektierenden Fläche (F) und einer zweiten, der ersten gegenüberliegenden Fläche versehen ist;
- einen Photovoltaikempfänger (R), der auf der zweiten Fläche des Strukturelements angeordnet ist;
- eine Schicht aus transparentem Einkapselungsmaterial (E), die den Photovoltaikempfänger bedeckt; und
- eine transparente Schutzschicht (FAV), die die Schicht aus transparentem Einkapselungsmaterial bedeckt; wobei die transparente Schutzschicht und die Schicht aus Einkapselungsmaterial mindestens die gesamte Oberfläche des Photovoltaikempfängers bedecken;
und dadurch, dass während des Laminierens die reflektierende Fläche des Strukturelements durch Inkontaktbringen mit einer konvexen Oberfläche einer Gegenform (CF) geformt wird, um die reflektierende Fläche mit einer vordefinierten konkaven geometrischen Form zu erhalten.

2. Verfahren zum Herstellen eines solaren photovoltaischen Konzentrationssubmoduls nach dem vorherigen Anspruch, wobei die vordefinierte konkave geometrische Form der reflektierenden Fläche parabolisch ist.

3. Verfahren zum Herstellen eines solaren photovoltaischen Konzentrationssubmoduls nach einem der vorherigen Ansprüche, wobei die Laminierung eine Heißlaminierung unter Vakuum ist, deren Temperatur vorzugsweise zwischen 120 °C und 170 °C liegt.

4. Verfahren zum Herstellen eines solaren photovoltaischen Konzentrationssubmoduls nach einem der vorherigen Ansprüche, wobei das Einkapselungsmaterial aus EVA, Polyolefin, Silikon, thermoplastischem Polyurethan, Polyvinylbutyral, funktionellem Polyolefin oder Ionomer besteht.

5. Verfahren zum Herstellen eines solaren photovoltaischen Konzentrationssubmoduls nach einem der vorherigen Ansprüche, wobei die transparente Schutzschicht aus ECTFE, FEP, PMMA, PC, ETFE, PVDF, PET, Glas oder CPI besteht.

6. Verfahren zum Herstellen eines solaren photovoltaischen Konzentrationssubmoduls nach einem der vorherigen Ansprüche, wobei der Photovoltaikempfänger eine Baugruppe von photovoltaischen Zellen ist, die durch Drähte auf einem Empfänger des PCB-SMI-Typs miteinander verbunden sind.

7. Verfahren zum Herstellen eines solaren photovoltaischen Konzentrationssubmoduls nach einem der Ansprüche 1 bis 5, wobei der Photovoltaikempfänger eine Baugruppe von photovoltaischen Zellen ist, die durch Bänder miteinander verbunden sind.

8. Verfahren zum Herstellen eines solaren photovoltaischen Konzentrationssubmoduls nach einem der Ansprüche 1 bis 7, wobei die photovoltaischen Zellen Siliciumzellen sind.

9. Verfahren zum Herstellen eines solaren photovoltaischen Konzentrationssubmoduls nach einem der Ansprüche 1 bis 7, wobei die photovoltaischen Zellen Multi-Junction-Zellen sind.

10. Verfahren zum Herstellen eines solaren photovoltaischen Konzentrationssubmoduls nach einem der vorherigen Ansprüche, wobei das Strukturelement aus einem von zwei Häuten umgebenen Kern besteht, wobei eine der beiden Häute mit einem reflektierenden Film bedeckt ist, der die erste reflektierende Fläche des Submoduls bildet.

11. Verfahren zum Herstellen eines solaren photovoltaischen Konzentrationssubmoduls nach Anspruch 10, wobei die Häute aus einem vorimprägnierten Polymer/Faser-Material bestehen, wobei das Polymer aus Polyester, Epoxy und Acryl ausgewählt ist und die Faser aus Glas, Kohlenstoff und Aramid ausgewählt ist.

12. Verfahren zum Herstellen eines solaren photovoltaischen Konzentrationssubmoduls nach Anspruch 10 oder 11, wobei der Kern eine Wabenstruktur, vorzugsweise aus Aluminium, Aramid vom Nomex-Typ, Polypropylen oder Polycarbonat, ist.

13. Verfahren zum Herstellen eines solaren photovoltaischen Konzentrationssubmoduls nach einem der Ansprüche 10 und 11, wobei der Kern ein Schaumstoff, vorzugsweise aus PET, PU, PVC, PEI oder PMI, ist.

14. Verfahren zum Herstellen eines solaren photovoltaischen Konzentrationssubmoduls nach einem der Ansprüche 10 bis 13, wobei der reflektierende Film ein Film aus polymerem Material ist, der eine Silber- oder Aluminiumablagerung enthält.

15. Verfahren zum Herstellen eines solaren photovoltaischen Konzentrationssubmoduls nach einem der Ansprüche 1 bis 9, wobei das Strukturelement einen Spiegel aus Aluminium umfasst.

## Claims

1. A method for manufacturing a concentrating photovoltaic solar sub-module provided with a reflective side having a concave predefined geometric shape, **characterised in that** it comprises laminating, in a single step, a multi-layer assembly comprising in succession:
- a structural element (P, RD, F) provided with a reflective first side (F) and a second side, opposite the first side;
- a photovoltaic receiver (R), placed on the second side of the structural element;
- a layer made of transparent encapsulating material (E), covering the photovoltaic receiver; and
- a transparent protective layer (FAV) covering the layer made of transparent encapsulating material; the transparent protective layer and the layer made of encapsulating material covering at least the entire surface of the photovoltaic receiver;
and **in that**, during the lamination, the reflective side of the structural element is shaped by being brought into contact with a convex surface of a counter-form (CF), to obtain the reflective side of concave predefined geometric shape.

2. The method for manufacturing a concentrating photovoltaic solar sub-module according to the preceding claim, wherein the concave predefined geometric shape of said reflective side is parabolic.

3. The method for manufacturing a concentrating photovoltaic solar sub-module according to one of the preceding claims, wherein said lamination is a hot vacuum lamination, the temperature of which is preferably comprised between 120 °C and 170 °C.

4. The method for manufacturing a concentrating photovoltaic solar sub-module according to one of the preceding claims, wherein the encapsulating material is made of EVA, polyolefin, silicone, thermoplastic polyurethane, polyvinyl butyral, functional polyolefin or ionomer.

5. The method for manufacturing a concentrating photovoltaic solar sub-module according to one of the preceding claims, wherein said transparent protective layer is made of ECTFE, FEP, PMMA, PC, ETFE, PVDF, PET, glass or CPI.

6. The method for manufacturing a concentrating photovoltaic solar sub-module according to one of the preceding claims, wherein said photovoltaic receiver is a set of photovoltaic cells that are interconnected by wires on an IMS-PCB receiver.

7. The method for manufacturing a concentrating photovoltaic solar sub-module according to one of claims 1 to 5, wherein said photovoltaic receiver is a set of photovoltaic cells that are interconnected by strips.

8. The method for manufacturing a concentrating photovoltaic solar sub-module according to one of claims 1 to 7, wherein said photovoltaic cells are silicon cells.

9. The method for manufacturing a concentrating photovoltaic solar sub-module according to one of claims 1 to 7, wherein said photovoltaic cells are multi-junction cells.

10. The method for manufacturing a concentrating photovoltaic solar sub-module according to one of the preceding claims, wherein said structural element is formed from a core flanked by two skins, one of the two skins being covered by a reflective film forming the reflective first side of the sub-module.

11. The method for manufacturing a concentrating photovoltaic solar sub-module according to claim 10, wherein said skins are made of preimpregnated polymer/fiber material, the polymer being chosen from polyester, epoxy or acrylic and the fiber being chosen from glass, carbon or aramid.

12. The method for manufacturing a concentrating photovoltaic solar sub-module according to one of claims 10 and 11, wherein the core is a honeycomb structure that is advantageously made of aluminium, of aramid of Nomex type, of polypropylene, or of polycarbonate.

13. The method for manufacturing a concentrating photovoltaic solar sub-module according to one of claims 10 and 11, wherein the core is a foam, advantageously made of PET, PU, PVC, PEI or PMI.

14. The method for manufacturing a concentrating photovoltaic solar sub-module according to one of claims 10 to 13, wherein said reflective film is a polymer film containing a silver or aluminium deposition.

15. The method for manufacturing a concentrating photovoltaic solar sub-module according to one of claims 1 to 9, wherein said structural element comprises an aluminium mirror.
